# EUROPEAN PATENT APPLICATION

(11) **EP 4 632 475 A1**
(43) Date of publication of application: **15.10.2025**
(21) Application number: 23948869.5
(22) Date of filing: 17.08.2023
(51) Int. Cl.: G02F 1/13357

(54) **LIGHT-EMITTING MODULE AND DISPLAY DEVICE**

(71) Applicant: Boe Technology Group Co., Ltd., Beijing 100015 (CN); Hefei Xinsheng Optoelectronics Technology Co., Ltd., Hefei, Anhui 230012 (CN)
(72) Inventor: DENG, Chuanfeng, Beijing 100176 (CN); LI, Youlu, Beijing 100176 (CN); WANG, Ning, Beijing 100176 (CN); LI, Hailong, Beijing 100176 (CN); LIU, Qiang, Beijing 100176 (CN); LIU, Yudong, Beijing 100176 (CN); WANG, Zhen, Beijing 100176 (CN); BAI, Jinglu, Beijing 100176 (CN); GENG, Meng, Beijing 100176 (CN)
(74) Representative: Haseltine Lake Kempner LLP
(86) International application number: PCT/CN2023/113454
(87) International publication number: WO 2025/035441

(57) **Abstract**

A light-emitting module (10) and a display device (00), relating to the technical field of display. The light-emitting module (10) comprises a first substrate (101), a plurality of first light-emitting units (102) located on the first substrate (101), a second substrate (103), and a plurality of second light-emitting units (104) located on the second substrate (103). Light emitted by the plurality of first light-emitting units (102) is projected in a direction away from the first substrate (101) through holes (103a) in the second substrate (103), and light emitted by the plurality of second light-emitting units (104) is also projected in the direction away from the first substrate (101), so that the light-emitting brightness of the light-emitting module (10) can be increased, thereby improving the display effect of the display device (00). In addition, because the plurality of first light-emitting units (102) and the plurality of second light-emitting units (104) are respectively arranged on two substrates, the light-emitting units arranged on each of the two substrates can be controlled independently, thereby avoiding the increase of power of a driving chip in the light-emitting module (10), avoiding local heating of the light-emitting module (10), and ensuring the product yield.

## Description

### TECHNICAL FIELD

The present disclosure relates to the field of display technologies, and in particular, relates to a light-emitting module and a display device.

### BACKGROUND

Mini light-emitting diodes (Mini LEDs) are often used to prepare high contrast or high brightness light-emitting modules due to their better local dimming performance.

### SUMMARY

Embodiments of the present disclosure provide a light-emitting module and a display device. The technical solutions are as follows.

In one aspect, a light-emitting module is provided. The light-emitting module includes:
a first substrate;
a plurality of first light-emitting units, disposed on a target side of the first substrate;
a second substrate, having a plurality of apertures corresponding to the plurality of first light-emitting units, wherein an orthographic projection of each of the apertures on the first substrate covers an orthographic projection of one of the first light-emitting units on the first substrate, and light emitted from the plurality of first light-emitting units is irradiated through the plurality of apertures toward a target direction, the target direction being a direction away from the first substrate; and
a plurality of second light-emitting units, disposed in a region, where the plurality of apertures are not formed, in a side, away from the first substrate, of the second substrate, wherein an orthographic projection of each of the second light-emitting units on the first substrate is not overlapped with the orthographic projection of the first light-emitting unit on the first substrate, and light emitted from the plurality of second light-emitting units is irradiated toward the target direction.

In some embodiments, each of the plurality of apertures has a first aperture close to the first substrate and a second aperture away from the first substrate;
wherein an area of an orthographic projection of the first aperture on the first substrate is less than or equal to an area of an orthographic projection of the second aperture on the first substrate, and the orthographic projection of the first aperture on the first substrate, is within the orthographic projection of the second aperture on the first substrate.

In some embodiments, each of the plurality of apertures includes a first aperture portion and a second aperture portion, the first aperture portion being close to the first substrate with respect to the second aperture portion; wherein
the first aperture portion has the first aperture and a third aperture opposite to the first aperture, wherein an area of an orthographic projection of the third aperture on the first substrate is equal to the area of the orthographic projection of the first aperture on the first substrate, and the orthographic projection of the third aperture on the first substrate is overlapped with the orthographic projection of the first aperture on the first substrate; and
the second aperture portion has the second aperture and a fourth aperture opposite to the second aperture, wherein the area of the orthographic projection of the second aperture on the first substrate is larger than an orthographic projection of the fourth aperture on the first substrate, and the orthographic projection of the second aperture on the first substrate covers the orthographic projection of the fourth aperture on the first substrate.

In some embodiments, the third aperture is in communication with the fourth aperture, the area of the orthographic projection of the third aperture on the first substrate is equal to an area of the fourth aperture on the first substrate, and the orthographic projection of the third aperture on the third aperture is overlapped with the orthographic projection of the fourth aperture on the first substrate; and
an area of a cross-section, parallel to a bearing surface of the first substrate, of the second aperture portion increases with an increase of a distance from the cross-section to the first substrate.

In some embodiments, the light-emitting module further includes: a first reflective portion and a second reflective portion; wherein
the first reflective portion is disposed between the first substrate and the second substrate, and an orthographic projection of the first reflective portion on the first substrate is not overlapped with the orthographic projections of the plurality of apertures on the first substrate; and
the second reflective portion is disposed on a side of the plurality of apertures.

In some embodiments, the light-emitting module further includes: a third reflective portion and a fourth reflective portion; wherein
the third reflective portion is disposed on the side, away from the first substrate, of the second substrate, and an orthographic projection of the third reflective portion on the first substrate is not overlapped with the orthographic projections of the plurality of second light-emitting units on the first substrate; and
the fourth reflective portion is disposed on a side of the plurality of apertures.

In some embodiments, wherein the light-emitting module further includes: a plurality of first protective portions corresponding to the plurality of first light-emitting units, and a plurality of second protective portions corresponding to the plurality of second light-emitting units; wherein
each of the plurality of first protective portions is disposed within one of the apertures and on a side, away from the first substrate, of the first light-emitting units, and an orthographic projection of each of the first protective portions on the first substrate covers the orthographic projection of the first light-emitting unit on the first substrate; and
each of the plurality of the second protective portions is disposed on a side, away from the first substrate, of one of the second light-emitting units, and an orthographic projection of each of the second protective portions on the first substrate covers the orthographic projection of the second light-emitting unit on the first substrate.

In some embodiments, a thickness of the first protective portion on a bearing surface perpendicular to the first substrate is less than or equal to a thickness of the second substrate.

In some embodiments, the light-emitting module further includes a control panel disposed on a side, away from the first substrate, of the plurality of second light-emitting units; wherein
the control panel includes a first polarizer layer, a liquid crystal cell, and a second polarizer layer that are laminated along the direction away from the first substrate;
the first polarizer layer has a first light-transmissive axis, and the first polarizer layer is configured to generate polarized light whose polarization direction is parallel to the first light-transmissive axis; and
the second polarizer layer has a second light-transmissive axis, and the second polarizer layer is configured to transmit polarized light whose polarization direction is parallel to the second light-transmissive axis and absorb polarized light whose polarization direction is perpendicular to the second light-transmissive axis.

In some embodiments, the control panel further includes: a plurality of control circuits arranged in an array, a plurality of first signal lines arranged along a first direction and extending along a second direction, and a plurality of second signal lines arranged along the second direction and extending along the first direction, the first direction being perpendicular to the second direction; wherein
the plurality of control circuits form a plurality of first control circuit groups arranged along the first direction, wherein each of the first control circuit groups includes a plurality of control circuits arranged along the second direction, and each of the first signal lines is connected to the plurality of control circuits in one of the first control circuit groups; and
the plurality of control circuits further form a plurality of second control circuit groups arranged along the second direction, wherein each of the second control circuit groups includes a plurality of control circuits arranged along the first direction, and each of the second signal lines is connected to the plurality of control circuits in one of the second control circuit groups;
wherein each of the control circuits is configured to drive deflection of liquid crystal molecules in the liquid crystal cell under control of the first signal line and the second signal line.

In some embodiments, a number of the control circuits is equal to a total number of the plurality of first light-emitting units and the plurality of second light-emitting units; and
each of the control circuits is configured to control deflection of liquid crystal molecules in the liquid crystal cell disposed in a region where one of the light-emitting units is disposed.

In some embodiments, the light-emitting module further includes: a color conversion layer disposed on a side, away from the first substrate, of the plurality of second light-emitting units;
light emitted from the plurality of first light-emitting units and the plurality of second light-emitting units is in a first color, and the color conversion layer includes a first color conversion portion, a second color conversion portion, and a transparent portion; and
the first color conversion portion is configured to convert light of the first color into light of a second color, the second color conversion portion is configured to convert the light of the first color into light of a third color, and the transparent portion is configured to transmit the light of the first color.

In some embodiments, the first substrate is a circuit board and the second substrate is a glass substrate; or
the first substrate and the second substrate are both glass substrates.

In some embodiments, the orthographic projections of the plurality of first light-emitting units on the first substrate and the orthographic projections of the plurality of second light-emitting units on the first substrate are staggered.

In some embodiments, wherein the plurality of first light-emitting units and the plurality of second light-emitting units are micro light-emitting diodes.

In another aspect, a display device is provided. The display device includes: a housing, an adhesive frame assembly, a display module, and the light-emitting module as described above;
wherein the housing and the adhesive frame assembly form a holding space, the light-emitting module is disposed in the holding space, the display module is disposed on a light-exiting side of the light-emitting module, and the light-emitting module is configured to provide backlighting for the display module.

In some embodiments, the housing is disposed on a non-light-exiting side of the light-emitting module, at least a portion of the housing is disposed on a side of the light-emitting module, the adhesive frame assembly is disposed on a side of the light-emitting module and is fixedly connected to the housing, and the adhesive frame assembly includes a step structure; and
at least a portion of a control panel in the light-emitting module is disposed on the step structure and/or, at least a portion of a color conversion layer in the light-emitting module is disposed on the step structure.

In some embodiments, a width of the step structure ranges from 0.4 mm to 0.5 mm; and
a width of a portion, overlapped with the step structure, of the control panel and/or the color conversion layer ranges from 0.25 mm to 0.3 mm.

In some embodiments, the display device further includes a diffuser film, a homogenizer film, and a prism assembly that are disposed between the light-emitting module and the display module and successively laminated, and a color film layer disposed on a side, away from the light-emitting module, of the display module;
wherein the diffuser film is configured to diffuse light emitted from the light-emitting module, the homogenizer film is configured to homogenize light, and the prism assembly is configured to converge light.

In some embodiments, the display module is a liquid crystal display module.

### BRIEF DESCRIPTION OF DRAWINGS

For clearer descriptions of the technical solutions in the embodiments of the present disclosure, the following briefly introduces the accompanying drawings to be required in the descriptions of the embodiments. Apparently, the accompanying drawings in the following description show merely some embodiments of the present disclosure, and persons of ordinary skills in the art may still derive other drawings from these accompanying drawings without creative efforts.
FIG. 1 is a schematic structural diagram of a light-emitting module according to some embodiments of the present disclosure;
FIG. 2 is a partial schematic diagram of a second substrate according to some embodiments of the present disclosure;
FIG. 3 is a schematic structural diagram of another light-emitting module according to some embodiments of the present disclosure;
FIG. 4 is a partial schematic diagram of another second substrate according to some embodiments of the present disclosure;
FIG. 5 is a schematic structural diagram of yet another light-emitting module according to some embodiments of the present disclosure;
FIG. 6 is a schematic structural diagram of yet another light-emitting module according to some embodiments of the present disclosure;
FIG. 7 is a schematic structural diagram of yet another light-emitting module according to some embodiments of the present disclosure;
FIG. 8 is a schematic structural diagram of yet another light-emitting module according to some embodiments of the present disclosure;
FIG. 9 is a schematic structural diagram of yet another light-emitting module according to some embodiments of the present disclosure;
FIG. 10 is a schematic structural diagram of yet another light-emitting module according to some embodiments of the present disclosure;
FIG. 11 is a schematic structural diagram of yet another light-emitting module according to some embodiments of the present disclosure;
FIG. 12 is a schematic structural diagram of yet another light-emitting module according to some embodiments of the present disclosure;
FIG. 13 is a top view of a first light-emitting unit and a second light-emitting unit according to some embodiments of the present disclosure;
FIG. 14 is a schematic structural diagram of yet another light-emitting module according to some embodiments of the present disclosure;
FIG. 15 is a partial top view of a control panel according to some embodiments of the present disclosure;
FIG. 16 is a top view of a light-emitting unit, a first signal line, and a second signal line according to some embodiments of the present disclosure;
FIG. 17 is a top view of a first light-emitting unit and a second protective portion according to some embodiments of the present disclosure;
FIG. 18 is a partial schematic diagram of a display device according to some embodiments of the present disclosure; and
FIG. 19 is a schematic structural diagram of a display module according to some embodiments of the present disclosure;

### DETAILED DESCRIPTION

The present disclosure is described in further detail with reference to the accompanying drawings, to clearly present the objects, technical solutions, and advantages of the present disclosure.

In the related art, the light-emitting module includes a substrate and a plurality of Mini LEDs disposed on the substrate. The plurality of Mini LEDs emit light.

However, due to the limitation of the precision of the manufacturing process, a distance between the Mini LEDs formed on the substrate is large, and thus the display effect of the display device is poor.

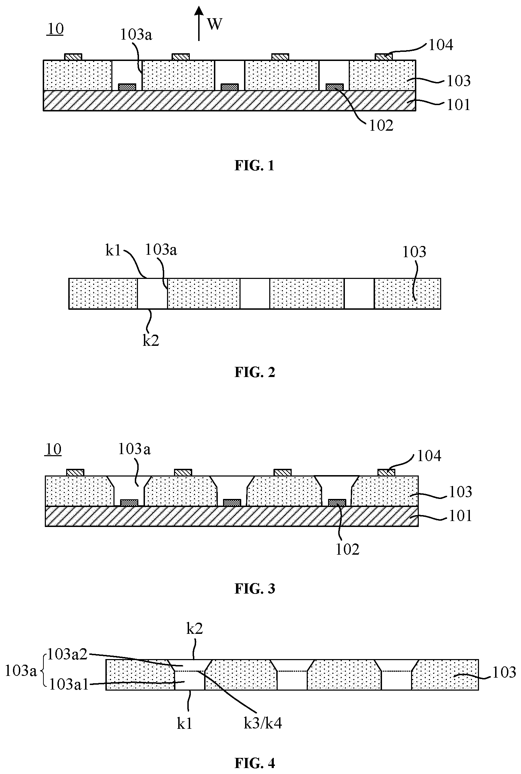

FIG. 1 is a schematic structural diagram of a light-emitting module according to some embodiments of the present disclosure. Referring to FIG. 1, the light-emitting module 10 includes a first substrate 101, a plurality of first light-emitting units 102, a second substrate 103, and a plurality of second light-emitting units 104.

Referring to FIG. 1, the plurality of first light-emitting units 102 are disposed on a target side of the first substrate 101. The target side of the first substrate 101 is configured to represent a light-exiting side of the light-emitting module 10. That is, the light emitted from the plurality of first light-emitting units 102 is directed toward the target side of the first substrate 101. That is, the light emitted from the plurality of first light-emitting units 102 is irradiated away from the first substrate 101.

The second substrate 103 has a plurality of apertures 103a corresponding to the plurality of first light-emitting units 102. For example, the plurality of first light-emitting units 102 are in one-to-one correspondence with the plurality of apertures 103a. That is, each of the first light-emitting units 102 corresponds to one of the apertures 103a. An orthographic projection of each aperture 103a on the first substrate 101 covers an orthographic projection of a corresponding first light-emitting unit 102 on the first substrate 101. As a result, the light emitted from the first light-emitting unit 102 is irradiated through the aperture 103a towards a target direction W, and the target direction W is a direction away from the first substrate 101.

The plurality of second light-emitting units 104 are disposed in a region where the plurality of apertures 103a are not formed in a side, away from the first substrate 101, of the second substrate 103. As a result, an orthographic projection of each second light-emitting unit 104 on the first substrate 101 is not overlapped with the orthographic projection of the first light-emitting unit 102 on the first substrate 101. Moreover, the light emitted from the second light-emitting unit 104 is also directed toward the target direction W.

In the embodiments of the present disclosure, the light emitted from the plurality of first light-emitting units 102 is irradiated toward the target direction W through the aperture 103a in the second substrate 103, and the light emitted from the plurality of second light-emitting units 104 is also irradiated toward the target direction W, such that the light-emitting module 10 irradiates light toward the target direction W.

Moreover, since the light-emitting module 10 includes the plurality of first light-emitting units 102 disposed on the first substrate 101 and the plurality of second light-emitting units 104 disposed on the second substrate 103, the arrangement density of light-emitting units disposed in the light-emitting module 10 is increased as compared to the scheme of disposing a plurality of light-emitting units on a single substrate, such that the luminance of the light-emitting module 10 is improved.

In the related art, to improve the luminance of the light-emitting module 10, it is necessary to increase the arrangement density of the light-emitting units in the light-emitting module 10 (i.e., increase the number of light-emitting units). In this case, there are too many light-emitting units controlled by a single driver chip, such that the power of the driver chip is increased, which leads to the local heating phenomenon in the light-emitting module 10, and thus it is easy defects in the process of relying, including defects such as polarization of liquid crystals and failure of the driver chip, leading to a lower yield of the product.

In some embodiments of the present disclosure, the plurality of first light-emitting units 102 and the plurality of second light-emitting units 104 are respectively disposed on two substrates, such that the light-emitting units disposed on the two substrates are controlled separately. For example, the plurality of first light-emitting units 102 are driven using a driver chip provided on the first substrate 101, and the plurality of second light-emitting units 104 are driven using a driver chip provided on the second substrate 103.

In this way, even if the arrangement density of the light-emitting units of the light-emitting module 10 increases, which improves the luminance of the light-emitting module 10, it does not lead to an increase in the number of light-emitting units controlled by a single driver chip, such that the power of the driver chip is not increased, which avoids the phenomenon of localized heating in the light-emitting module 10, and thus the yield of the product is ensured.

In summary, some embodiments of the present disclosure provide a light-emitting module. The light-emitting module includes the first substrate, the plurality of first light-emitting units disposed on the first substrate, the second substrate, and the plurality of second light-emitting units disposed on the second substrate. The light emitted from the plurality of first light-emitting units is irradiated toward the direction away from the first substrate through the aperture in the second substrate, and the light emitted from the plurality of second light-emitting units is also irradiated toward the direction away from the first substrate, such that the luminance of the light-emitting module is improved, and thereby the display effect of the display device is improved. Moreover, since the plurality of first light-emitting units and the plurality of second light-emitting units are respectively disposed on two substrates, the light-emitting units disposed on the two substrates are controlled separately, which avoids an increase in the power of the driver chip in the light-emitting module, such that the phenomenon of localized heat generation in the light-emitting module is avoided, and the yield of the product is ensured.

In some embodiments of the present disclosure, a side, close to the second substrate 103, of the first substrate 101, and a side, close to the first substrate 101 of the second substrate 103 are fixed by adhesive bonding. For example, bonding regions of the first substrate 101 and the second substrate 103 are peripheral regions, and the adhesive material in such a case is a white dam adhesive. Bonding portions of the second substrate 103 and the second substrate 103 are middle regions, in which case the adhesive material is a dot adhesive.

FIG. 2 is a partial schematic diagram of a second substrate according to some embodiments of the present disclosure. Referring to FIG. 2, the aperture 103a in this second substrate 103 has a first aperture k1 close to the first substrate 101, and a second aperture k2 away from the first substrate 101. An area of an orthographic projection of the first aperture k on the first substrate 101 is less than or equal to an area of an orthographic projection of the second aperture k2 on the first substrate 101, and the orthographic projection of the first aperture k1 is lies within the orthographic projection of the second aperture k2 on the first substrate 101.

Combining FIGS. 1 and 2, the area of the orthographic projection of the first aperture k1 on the first substrate 101 is equal to the area of the orthographic projection of the second aperture k2 on the first substrate 101. For example, the aperture 103a is a cylindrical aperture, where an area of a cross portion, parallel to a bearing surface of the first substrate 101, of the cylindrical aperture does not change with increasing distance from the first substrate 101.

FIG. 3 is a schematic structural diagram of another light-emitting module according to some embodiments of the present disclosure. FIG. 4 is a partial schematic diagram of another second substrate according to some embodiments of the present disclosure. Combining FIGS. 3 and 4, the aperture 103a includes a first aperture portion 103a1 and a second aperture portion 103a2. The first aperture portion 103a1 is close to the first substrate 101 with respect to the second aperture portion 103a2.

The first aperture portion 103a1 has a first aperture k1, and a third aperture k3 disposed opposite the first aperture k1. An area of an orthographic projection of the third aperture k3 on the first substrate 101 is equal to the area of the orthographic projection of the first aperture k1 on the first substrate 101, and the orthographic projection of the third aperture k3 on the first substrate 101 is overlapped with the orthographic projection of the first aperture k1 on the first substrate 101. That is, the first aperture portion 103a1 is a cylindrical aperture portion of the aperture 103a, and an area of a cross-section, parallel to the bearing surface of the first substrate 101, of this first aperture portion 103a1 does not change with increasing distance from the first substrate 101.

The second aperture portion 103a2 has a second aperture k2, and a fourth aperture k4 disposed opposite the second aperture k2. An area of an orthographic projection of the second aperture k2 on the first substrate 101 is larger than an orthographic projection of the fourth aperture k4 on the first substrate 101, and the orthographic projection of the second aperture k2 on the first substrate 101 covers the orthographic projection of the fourth aperture k4 on the first substrate 101.

Referring to FIG. 4, the third aperture k3 is in communication with the fourth aperture k4, and the area of the orthographic projection of the third aperture k3 on the first substrate 101 and the area of the fourth aperture k4 on the first substrate 101 are equal, and the orthographic projection of the third aperture k3 on the first substrate 101 is overlapped with the orthographic projection of the fourth aperture k4 on the first substrate 101. For example, the third aperture k3 of the first aperture portion 103a1 and the fourth aperture k4 of the second aperture portion 103a2 are the same aperture. Referring to FIGS. 3 and 4, the area of the cross-section, parallel to the bearing surface of the first substrate 101, of the second aperture portion 103a2 increases with increasing distance of the cross-section from the first substrate 101. For example, the second aperture portion 103a2 is an inverted trapezoidal-shaped aperture portion of the aperture 103a.

As a result, the aperture 103a includes a cylindrical aperture portion and an inverted trapezoidal aperture portion, such that the aperture 103a formed in the second substrate 103 has a roughly T-shaped structure, which in turn ensures that the light emitted from the first light-emitting unit 102 can exit from the aperture 103a, and thus the light-emitting effect of the first light-emitting unit 102 is ensured.

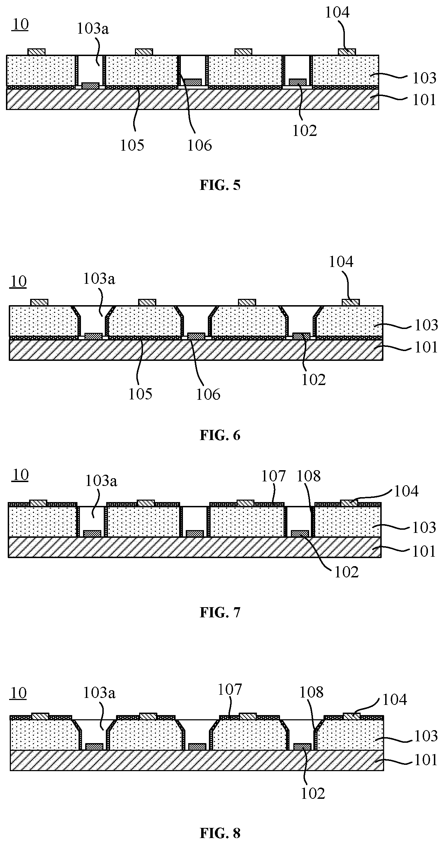

FIG. 5 is a schematic structural diagram of yet another light-emitting module according to some embodiments of the present disclosure. FIG. 6 is a schematic structural diagram of yet another light-emitting module according to some embodiments of the present disclosure. Referring to FIGS. 5 and 6, the light-emitting module 10 further includes a first reflective portion 105 and a second reflective portion 106. The first reflective portion 105 is disposed between the first substrate 101 and the second substrate 103, and an orthographic projection of the first reflective portion 105 on the first substrate 101 and an orthographic projection of the plurality of apertures 103a on the first substrate 101 are not overlapped. The second reflective portion 106 is disposed on a side of the plurality of apertures 103a. In some embodiments, the first reflective portion 105 and the second reflective portion 106 are white oil films.

By providing the first reflective portion 105 between the first substrate 101 and the second substrate 103, it is possible to cause the first reflective portion 105 to reflect light irradiated onto the first reflective portion 105, such that the light emitted from the plurality of first light-emitting units 102 and the plurality of second light-emitting units 104 is prevented from exiting along an opposite direction of the target direction W. As a result, the total amount of light exited from the target direction W is increased, and the luminance of the light-emitting module 10 is increased.

Further, by providing the second reflective portion 106 on the side of the plurality of apertures 103a, the second reflective portion 106 is thereby made to reflect the light irradiated to the second reflective portion 106, such that the effect of converging the light is achieved, and thus the luminance of the light-emitting module 10 is improved.

The light irradiated to the first reflective portion 105 includes light emitted by the first light-emitting unit 102, and/or, light emitted by the second light-emitting unit 104. The light irradiated onto the second reflective portion 106 includes light emitted by the first light-emitting unit 102, and/or, light emitted by the second light-emitting unit 104. That is, both the light emitted by the first light-emitting unit 102 and the light emitted by the second light-emitting unit 104 may irradiate to the first reflective portion 105 or to the second reflective portion 106.

FIG. 7 is a schematic structural diagram of yet another light-emitting module according to some embodiments of the present disclosure. FIG. 8 is a schematic structural diagram of yet another light-emitting module according to some embodiments of the present disclosure. Referring to FIGS. 7 and 8, the light-emitting module 10 further includes a third reflective portion 107 and a fourth reflective portion 108. The third reflective portion 107 is disposed on a side, away from the first substrate 101, of the second substrate 103, and an orthographic projection of the third reflective portion 107 on the first substrate 101 is not overlapped with the orthographic projection of the plurality of second light-emitting units 104 on the first substrate 101. The fourth reflective portion 108 is disposed on a side of the plurality of apertures 103a. In some embodiments, the first reflective portion 107 and the second reflective portion 108 are white oil films.

By providing the third reflective portion 107 on the side, away from the first substrate 101, of the second substrate 103, the third reflective portion 107 is thereby made capable of reflecting the light irradiated onto the third reflective portion 107, and the light emitted from the plurality of first light-emitting units 102 and the plurality of second light-emitting units 104 is prevented from exiting along the opposite direction of the target direction W. As a result, the total amount of light emitted from the target direction W is increased, such that the luminance of the light-emitting module 10 is increased.

Further, by providing the fourth reflective portion 108 on the side of the plurality of apertures 103a, the fourth reflective portion 108 is thus made to reflect the light irradiated to the fourth reflective portion 108, such that the effect of converging the light is achieved, and thus the luminance of the light-emitting module 10 is improved.

the light irradiated to the third reflection portion 107 includes the light emitted by the first light-emitting unit 102, and/or, the light emitted by the second light-emitting unit 104. The light irradiated to the fourth reflective portion 108 includes the light emitted by the first light-emitting unit 102, and/or, the light emitted by the second light-emitting unit 104. That is, both the light emitted by the first light-emitting unit 102, and the light emitted by the second light-emitting unit 104 may irradiate to the third reflective portion 107, or irradiate to the fourth reflective portion 108.

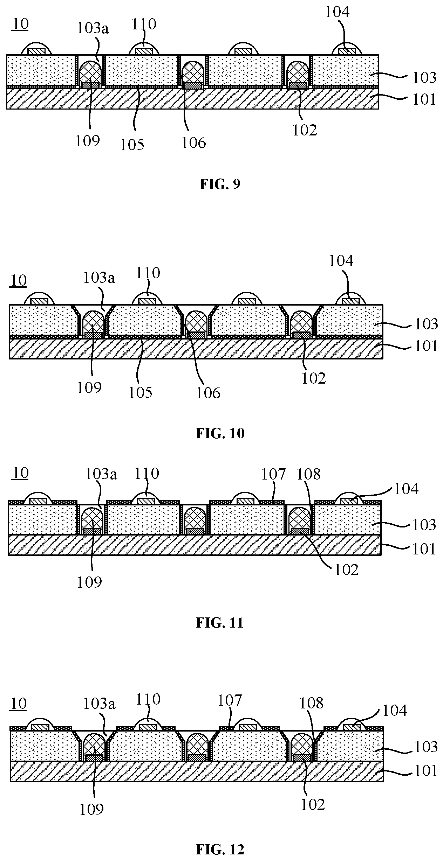

Referring to FIGS. 9 to 12, the light-emitting module 10 further includes a plurality of first protective portions 109 corresponding to the plurality of first light-emitting units 102, and a plurality of second protective portions 110 corresponding to the plurality of second light-emitting units 104.

Each first protective portion 109 is within one of the apertures 103a and is disposed on a side, away from the first substrate 101, of the first light-emitting units 102. An orthographic projection of each first protective portion 109 on the first substrate 101 covers the orthographic projection of the first light-emitting unit 102 on the first substrate 101. Thus, by providing the first protective portions 109, the first light-emitting unit 102 is avoided from being bumped by other devices, and the yield of the first light-emitting unit 102 is ensured.

Moreover, each second protective portion 110 is disposed on a side, away from the first substrate 101, of one of the second light-emitting units 104, and an orthographic projection of each second protective portion 110 on the first substrate 101 covers the orthographic projection of the second light-emitting unit 104 on the first substrate 101. Thus, by providing the second protective portions 110, the second light-emitting unit 104 is avoided from being bumped by other devices, and the yield of the second light-emitting unit 104 is ensured.

In some embodiments, both the first protective portion 109 and the second protective portion 110 are transparent adhesive materials. A thickness of the first protective layer on a bearing surface perpendicular to the first substrate 101 is less than or equal to a thickness of the second substrate 103. This prevents the first protective portion 109 from protruding from a surface, away from the first substrate 101, of the second substrate 103, and thus the protective effect of the first protective portion 109 on the first light-emitting unit 102 is ensured.

Exemplarily, the second substrate 103 has a thickness of about 0.7 mm. The thickness of the first protective portion 109 on the bearing surface perpendicular to the first substrate 101 is 0.6 mm.

The process of preparing the light-emitting module 10 includes: acquiring the first substrate 101 and the plurality of first light-emitting units 102 disposed on the first substrate 101; coating the first protective portion 109 on the side, away from the first substrate 101, of the plurality of first light-emitting units 102; acquiring the second substrate 103 and the plurality of second light-emitting units 104 disposed on the second substrate 103; assembling the second substrate 103 and the first substrate 101; and causing the first light-emitting units 102 to be embedded in the apertures 103a of the second substrate 103. In this way, since the first protective portion 109 has a certain thickness, this first protective portion 109 has an alignment effect when aligning the first substrate 101 and the second substrate 103, such that the alignment accuracy of the first substrate 101 and the second substrate 103 is ensured.

Since the first light-emitting unit 102 is embedded in the aperture 103a of the second substrate 103, it is necessary to make the orthographic projection of the aperture 103a on the first substrate 101 cover the orthographic projection of the first light-emitting unit 102 on the first substrate 101, and thre is a bap between the aperture 103a and the first light-emitting unit 102.

For example, a length of an LED chip with the smallest length in the existing Mini-LEDs is about 0.3 mm. Considering that the first light-emitting unit 102 is welded to the first substrate 101, its length after welding is about 0.4 mm. As a result, to enable the first light-emitting unit 102 to be embedded in the aperture 103a, it is therefore necessary to make a diameter of the aperture 103a more than 0.4mm, such as a diameter of 0.5mm for the aperture 103a.

Alternatively, the diameter of the aperture 103a is designed according to the actual reserved space. Typically, an MNT light panel includes 5000 light-emitting units, and a spacing between adjacent light-emitting units is about 6mm. Therefore, the aperture 103a with a diameter of 0.5mm is designed at a position of about 3mm from the light-emitting units (a center of the aperture 103a is disposed at a position roughly in the middle of the light-emitting units).

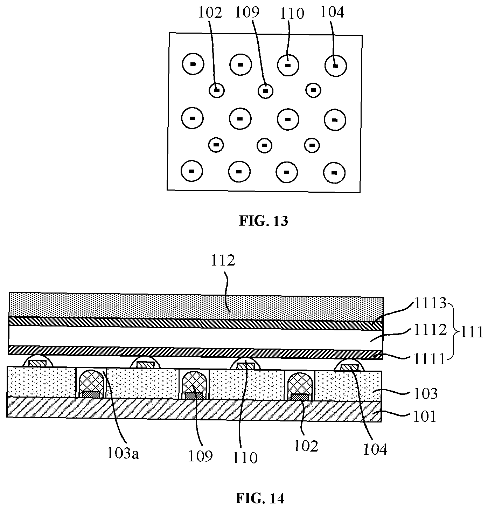

Further, since the first light-emitting unit 102 is within the aperture 103a, the first protective portion 109 for packaging the first light-emitting unit 102 also needs to be within the aperture 103a. However, the diameter of the aperture 103a is limited, and the design of the second protective portion 110 is not limited by the aperture 103a. Therefore, typically, with reference to FIG. 13, the area of the orthographic projection of the first protective portion 109 on the first substrate 101 is smaller than the area of the orthographic projection of the second protective portion 110 on the first substrate 101. Of course, the area of the orthographic projection of the first protective portion 109 on the first substrate 101 is also equal to or greater than the area of the orthographic projection of the second protective portion 110 on the first substrate 101, which is not limited herein.

FIG. 14 is a schematic structural diagram of another light-emitting module according to some embodiments of the present disclosure. Referring to FIG. 14, the light-emitting module 10 further includes a control panel 111 disposed on a side, away from the first substrate 101, of the plurality of second light-emitting units 104. The control panel 111 includes a first polarizer layer 1111, a liquid crystal cell 1112, and a second polarizer layer 1113 that are stacked along the direction away from the first substrate 101.

The first polarizer layer 1111 has a first light-transmissive axis, and the first polarizer layer 1111 is configured to generate light whose polarization direction is parallel to the first light-transmissive axis. For example, after the light emitted from the plurality of first light-emitting units 102 and the plurality of second light-emitting units 104 is irradiated to the first polarizer layer 1111, the first polarizer layer 1111 converts the light into polarized light whose polarization direction is parallel to the first light-transmissive axis.

The second polarizer layer 1113 has a second light-transmissive axis, and the second polarizer layer 1113 is for transmitting polarized light whose polarization direction is parallel to the second light-transmissive axis, and for absorbing polarized light whose polarization direction is perpendicular to the second light-transmissive axis.

After the first polarizer layer 1111 converts the light into polarized light whose polarization direction is parallel to the first light-transmissive axis, the polarized light is irradiated to the second polarizer layer 1113 by the liquid crystal cell 1112. The polarized light may or may not have changed its polarization direction after passing through the liquid crystal cell 1112 (wherein the polarized light after passing through the liquid crystal cell 1112 is linearly polarized light, elliptically polarized light, or circularly polarized light). Regardless of whether the change occurs or not, in a case where the polarization direction of the polarized light irradiated to the second polarizer layer 1113 is parallel to the second light-transmissive axis, it is transmitted through the second polarizer layer 1113 and thus irradiated toward the target direction W, and is in a bright state; in aces where the polarization direction of the polarized light irradiated to the second polarizer layer 1113 is not parallel (e.g., perpendicular) to the second light-transmissive axis, it is absorbed by the second polarizer layer 1113, and the light cannot be exited from the target direction W, and is in a dark state.

In some embodiments of the present disclosure, the control panel 111 is designed on the light-exiting side of the light-emitting module 10, whereby the deflection of the liquid crystal molecules in the liquid crystal cell 1112 is controlled by the control panel 111, such that whether the light can pass through or not is controlled, and thus the light-emitting region of the light-emitting module is controlled.

In some embodiments, the liquid crystal cell 1112 is a twisted nematic (TN) liquid crystal cell, an in-plane switching (IPS) liquid crystal cell, or a multi-quadrant vertical alignment (VA) liquid crystal cell. Alternatively, the advanced super dimension switch (ADS) technology adopts the IPS liquid crystal cell, where a difference between ADS and IPS is a difference in electrode design.

For the TN liquid crystal cell, the orientation of the liquid crystal molecules in the liquid crystal cell 1112 close to the first polarizer layer 1111 is perpendicular to the orientation of the liquid crystal molecules in the liquid crystal layer close to the second polarizer layer 1113. Without power, the polarization direction of the polarized light is deflected by 90° (degrees) after passing through the liquid crystal cell 1112. For the IPS liquid crystal cell, the orientation of the liquid crystal molecules of the liquid crystal cell 1112 close to the first polarizer layer 1111 is parallel to the orientation of the liquid crystal molecules of the liquid crystal cell 1112 close to the second polarizer layer 1113. Without power, the polarization direction of the polarized light remains unchanged after passing through the liquid crystal cell 1112. For the VA liquid crystal cell, the orientation of the liquid crystal molecules of the liquid crystal cell 1112 close to the first polarizer layer 1111 is parallel to the orientation of the liquid crystal molecules of the liquid crystal cell 1112 close to the second polarizer layer 1113. Without power, the polarization direction of the polarized light remains unchanged after passing through the liquid crystal cell 1112.

In a first case, where the liquid crystal cell 1112 is the TN liquid crystal cell and the control panel 111 is in a constant white mode, the orientation of the liquid crystal molecules and the light-transmissive axis are designed as follows. The first light-transmissive axis of the first polarizer layer 1111 is parallel to the orientation of the liquid crystal molecules, close to the first polarizer layer 1111, of the TN liquid crystal cell, and the second light-transmissive axis of the second polarizer layer 1113 is parallel to the orientation of the liquid crystal molecules of the TN liquid crystal cell close to the second polarizer layer 1113. The constant white mode means that without power, the light is capable of exiting and it is in a bright state; and with power, the light cannot exit and it is in a dark state.

In the case where the liquid crystal cell 1112 is not powered, after the light (the light emitted by the first light-emitting unit 102 or the second light-emitting unit 104) is incident to the first polarizer layer 1111, the first polarized light (linearly polarized light) whose polarization direction is parallel to the first light-transmissive axis is generated. The direction polarization of the first polarized light is rotated by 90° after passing through the TN liquid crystal cell, and thus the second polarized light (linearly polarized light) is acquired. The polarization direction of this second polarized light is parallel to the second light-transmissive axis of the second polarizer, and this second polarized light is capable of exiting through the second polarizer layer 1113, such that the constant white mode is achieved, i.e., in a bright state.

In the case where the liquid crystal cell 1112 is powered, after the light (the light emitted from the first light-emitting unit 102 or the second light-emitting unit 104) is incident to the first polarizer layer 1111, the first polarized light (linearly polarized light) whose polarization direction is parallel to the first light-transmissive axis is generated. The polarization direction of the first polarized light remains unchanged after the first polarized light passes through the TN liquid crystal cell, i.e. it is still the first polarized light. Since the polarization direction of the first polarized light is perpendicular to the second light-transmissive axis of the second polarizer, this first polarized light cannot exit through the second polarizer layer 1113, such that a black state is achieved, i.e. in a dark state.

In this first case, as long as the first light-transmissive axis of the first polarizer layer 1111 is perpendicular to the second light-transmissive axis of the second polarizer layer 1113, the above-mentioned constant white mode of the TN liquid crystal cell is achieved. The initial orientation of the liquid crystal molecules in the TN liquid crystal cell is at an arbitrary angle.

In a second case, where the liquid crystal cell 1112 is the TN liquid crystal cell and the control panel 111 is in a constant black mode, the orientation of the liquid crystal molecules and the light-transmissive axis are designed as follows. The first light-transmissive axis of the first polarizer layer 1111 is parallel to the orientation direction of the liquid crystal molecules of the TN liquid crystal cell close to the first polarizer layer 1111, and the second light-transmissive axis of the second light transmission layer 1113 is perpendicular to the orientation direction of the liquid crystal molecules of the TN liquid crystal cell close to the second polarizer layer 1113. The constant dark mode means: that without power, the light cannot exit and it is in a dark state; with power, the light can exit and it is in a bright state.

In the case where the liquid crystal cell 1112 is not powered, after the light (the light emitted from the first light-emitting unit 102 or the second light-emitting unit 104) is incident to the first polarizer layer 1111, the first polarized light (linearly polarized light) whose polarization direction is parallel to the first light-transmissive axis is generated. The polarization direction of the first polarized light is rotated by 90° after passing through the TN liquid crystal cell, such that the second polarized light (linearly polarized light) is acquired. The polarization direction of this second polarized light is perpendicular to the second light-transmissive axis of the second polarizer layer 1113, such that the light from the second polarized light is absorbed by the second polarizer layer 1113, and no light exits, such that a black state is achieved, i.e., it is in a dark state.

In the case where the liquid crystal cell 1112 is powered, after the light (the light emitted from the first light-emitting unit 102 or the second light-emitting unit 104) incident to the first polarizer layer 1111, the first polarized light (linearly polarized light) whose polarization direction is parallel to the first light-transmissive axis is generated. The polarization direction of the first polarized light remains unchanged after the first polarized light passes through the TN liquid crystal cell, i.e. it is still the first polarized light. Since the polarization direction of the first polarized light is parallel to the second light-transmissive axis of the second polarizer layer 1113, the first polarized light can exit through the second polarizer layer 1113 to achieve a white state, i.e., a bright state.

In this second case, as long as the first light-transmissive axis of the first polarizer layer 1111 is parallel to the second light-transmissive axis of the second polarizer layer 1113, the above-mentioned constant black mode of the TN liquid crystal cell is achieved. The initial orientation of the liquid crystal molecules in the TN liquid crystal cell is at an arbitrary angle.

In a third case, where the liquid crystal cell 1112 is the IPS liquid crystal cell and the control panel 111 is in a constant white mode, the orientation of the liquid crystal molecules and the light-transmissive axis are designed as follows. The first light-transmissive axis of the first polarizer layer 1111 is parallel to the orientation direction of the liquid crystal molecules of the IPS liquid crystal cell close to the first polarizer layer 1111, and the second light-transmissive axis of the second polarizer layer 1113 is parallel to the orientation direction of the liquid crystal molecules of the IPS liquid crystal cell close to the second polarizer layer 1113.

In a case where the liquid crystal cell 1112 is not powered, after the light (the light emitted from the first light-emitting unit 102 or the second light-emitting unit 104) is incident to the first polarizer layer 1111, the first polarized light (linearly polarized light) whose polarization direction is parallel to the first light-transmissive axis is generated. This first polarized light is changed to the second polarized light after passing through the IPS liquid crystal cell (since the liquid crystal cell 1112 does not function without power, the second polarized light and the first polarized light have the same polarization direction). The polarization direction of this second polarized light is parallel to the second light-transmissive axis of the second polarizer layer 1113. This second polarized light can exit through the second polarizer layer 1113 to achieve a constant white mode, i.e. a bright state.

In a case where the liquid crystal cell 1112 is powered, after the light (the light emitted from the first light-emitting unit 102 or the second light-emitting unit 104) is incident to the first polarizer layer 1111, the first polarized light (linearly polarized light) whose polarization direction is parallel to the first light-transmissive axis is generated. The first polarized light is changed into the second polarized light (elliptically polarized light) after passing through the IPS liquid crystal cell, and the polarization direction of the effectively polarized light (the elliptically polarized light is decomposed into two mutually perpendicular polarized components of the linearly polarized light, the linearly polarized light with the larger component is defined as the effectively polarized light, and the polarization direction of the linearly polarized light with the larger component is the polarization direction of the effectively polarized light) of this second polarized light is perpendicular to the second light-transmissive axis of the second polarizer layer 1113, and this second polarized light cannot exit through the second polarizer layer 1113, such that a black state, i.e. a dark state is achieved.

In this third case, as long as the first light-transmissive axis of the first polarizer layer 1111 is parallel to the second light-transmissive axis of the second polarizer layer 1113, the constant white mode of the IPS liquid crystal cell as described above is achieved, and the initial orientation of the liquid crystal molecules in the IPS LCD cartridge is at any angle.

In a fourth case, where the liquid crystal cell 1112 is the IPS liquid crystal cell and the control panel 111 is in a constant black mode, the orientation of the liquid crystal molecules and the light-transmissive axis are designed as follows. The first light-transmissive axis of the first polarizer layer 1111 is parallel to the orientation direction of the liquid crystal molecules of the IPS liquid crystal cell close to the first polarizer layer 1111, and the second light-transmissive axis of the second light transmission layer 1113 is perpendicular to the orientation of the liquid crystal molecules of the IPS liquid crystal cell close the second polarizer layer 1113.

In a case where the liquid crystal cell 1112 is not powered, after the light (the light emitted from the first light-emitting unit 102 or the second light-emitting unit 104) is incident to the first polarizer layer 1111, the first polarized light (linearly polarized light) whose polarization direction is parallel to the first light-transmissive axis is generated. This first polarized light is changed to the second polarized light after passing through the IPS liquid crystal cell (since the liquid crystal cell 1112 does not function without power, the second polarized light and the first polarized light have the same polarization direction). The polarization direction of this second polarized light is perpendicular to the second light-transmissive axis of the second polarizer layer 1113, such that this second polarized light cannot exit through the second polarizer layer 1113, such that a constant black mode, i.e. a dark state is achieved.

In a case where the liquid crystal cell 1112 is powered, after the light (the light emitted from the first light-emitting unit 102 or the second light-emitting unit 104) is incident to the first polarizer layer 1111, the first polarized light (linearly polarized light) whose polarization direction is parallel to the first light-transmissive axis is generated. The first polarized light is changed into the second polarized light (elliptically polarized light) after passing through the IPS liquid crystal cell. The polarization direction of the effectively polarized light of the second polarized light (the elliptically polarized light is decomposed into two mutually perpendicular polarized components of the linearly polarized light, the linearly polarized light with the larger component is defined as the effectively polarized light, and the polarization direction of the linearly polarized light with the larger component is the polarization direction of the effectively polarized light) is parallel to the second light-transmissive axis of the second polarizer layer 1113, and therefore, the effectively polarized light of the second polarized light can exit through the second polarizer layer 1113, such that a white state, i.e. a bright state is achieved.

In this fourth case, as long as the first light-transmissive axis of the first polarizer layer 1111 is perpendicular to the second light-transmissive axis of the second polarizer layer 1113, the above-mentioned constant black mode of the IPS liquid crystal cell is achieved. The initial orientation of the liquid crystal molecules in the IPS liquid crystal cell is at any angle.

In a fifth case, where the liquid crystal cell 1112 is a VA liquid crystal cell and the control panel 111 is in a constant white mode, the orientation of the liquid crystal molecules and the light-transmissive axis are designed as follows. The first light-transmissive axis of the first polarizer layer 1111 is parallel to the second light-transmissive axis of the second polarizer layer 1113. The VA liquid crystal cell is oriented according to any of the orientation modes of the VA.

In a case where the liquid crystal cell 1112 is not powered, after the light (the light emitted from the first light-emitting unit 102 or the second light-emitting unit 104) is incident to the first polarizer layer 1111, the first polarized light (linearly polarized light) whose polarization direction is parallel to the first light-transmissive axis is generated. This first polarized light is changed to the second polarized light after passing through the VA liquid crystal cell (since the liquid crystal cell 1112 does not function without power, the second polarized light and the first polarized light have the same polarization direction). The polarization direction of this second polarized light is parallel to the second light-transmissive axis of the second polarizer, such that this second polarized light can exit through the second polarizer layer 1113, and thus a constant white mode, i.e. a bright state is achieved.

In a case where the liquid crystal cell 1112 is powered, after the light (the light emitted from the first light-emitting unit 102 or the second light-emitting unit 104) is incident to the first polarizer layer 1111, the first polarized light (linearly polarized light) whose polarization direction is parallel to the first light-transmissive axis is generated. The first polarized light changes to the second polarized light (elliptically polarized light) after passing through the VA liquid crystal cell. The polarization direction of the effectively polarized light of this second polarized light (the elliptically polarized light is decomposed into two mutually perpendicular polarized components of the linearly polarized light, the linearly polarized light with the larger component is defined as the effectively polarized light, and the polarization direction of the linearly polarized light with the larger component is the polarization direction of the effectively polarized light) is perpendicular to the second light-transmissive axis of the second polarizer layer 1113, and therefore, the effectively polarized light of the second polarized light cannot exit from the second polarizer layer 1113, and thus a black state, i.e. a dark state is achieved.

In a sixth case, where the liquid crystal cell 1112 is the VA liquid crystal cell and the control panel 111 is in a constant black mode, the orientation of the liquid crystal molecules and the light-transmissive axis are designed as follows. The first light-transmissive axis of the first polarizer layer 1111 is perpendicular to the second light-transmissive axis of the second polarizer layer 1113. The VA liquid crystal cell is oriented according to any of the orientation modes of the VA.

In a case where the liquid crystal cell 1112 is not powered, after the light (the light emitted from the first light-emitting unit 102 or the second light-emitting unit 104) is incident to the first polarizer layer 1111, the first polarized light (linearly polarized light) whose polarization direction is parallel to the first light-transmissive axis is generated. This first polarized light is changed to the second polarized light after passing through the VA liquid crystal cell (since the liquid crystal cell 1112 does not function without power, the second polarized light and the first polarized light have the same polarization direction). The polarization direction of this second polarized light is perpendicular to the second light-transmissive axis of the second polarizer layer 1113, such that this second polarized light cannot exit from the second polarized light, and thus a constant dark mode, i.e. a dark state is achieved.

In a case where the liquid crystal cell 1112 is powered, after the light (the light emitted from the first light-emitting unit 102 or the second light-emitting unit 104) is incident to the first polarizer layer 1111, the first polarized light (linearly polarized light) whose polarization direction is parallel to the first light-transmissive axis is generated. The first polarized light changes to the second polarized light (elliptically polarized light) after passing through the VA liquid crystal cell. The polarization direction of the effectively polarized light of the second polarized light (the elliptically polarized light is decomposed into two mutually perpendicular polarized components of the linearly polarized light, the linearly polarized light with the larger component is defined as the effectively polarized light, and the polarization direction of the linearly polarized light of the larger component is the polarization direction of the effectively polarized light) is parallel to the second light-transmissive axis of the second polarizer layer 1113, and therefore, the effectively polarized light of the second polarized light can exit through the second polarizer layer 1113, such that a white state, i.e. a bright state is achieved.

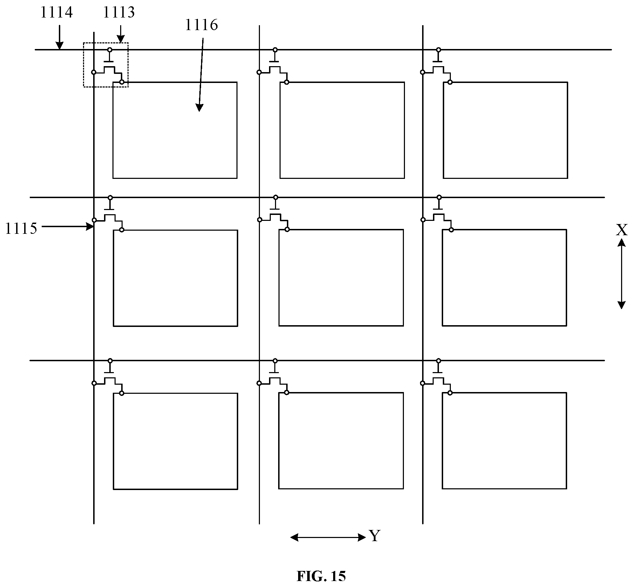

Referring to FIG. 15, the control panel 111 further includes a plurality of control circuits 1114 arranged in an array, a plurality of first signal lines 1115 arranged along a first direction X and extending along a second direction Y, and a plurality of second signal lines 1116 arranged along the second direction Y and extending along the first direction X. The first direction X and the second direction Y are perpendicular. For example, the first direction X is a pixel column direction of the control panel 111, and the second direction Y is a pixel row direction of the control panel 111.

In some embodiments, the plurality of control circuits 1114 form a plurality of first control circuit groups A1 arranged along the first direction X. Each of the first control circuit groups A1 includes a plurality of control circuits 1114 arranged along the second direction Y. Each of the first signal lines 1115 is connected to the plurality of control circuits 1114 in one of first control circuit groups A1. That is, each first signal line 1115 is used to provide first signals to the plurality of control circuits 1114 in one of the first control circuit groups A1.

The plurality of control circuits 1114 also form a plurality of second control circuit groups A2 arranged along the second direction Y. Each second control circuit group A2 includes a plurality of control circuits 1114 arranged along the first direction X. Each second signal line 1116 is connected to the plurality of control circuits 1114 in one of second control circuit groups A2. That is, each second signal line 1116 is used to provide second signals to the plurality of control circuits 1114 in one of the second control circuit groups A2.

Each of the control circuits 1114 is used to drive the liquid crystal molecules in the liquid crystal cell 1112 to deflect under the control of the first signal line 1115 and the second signal line 1116.

In some embodiments of the present disclosure, the control panel 111 further includes a pixel electrode 1117 and a common electrode (not shown in the figures). The control circuit 1114 in the control panel 111 is a switching transistor (TFT). The switching transistor includes a gate electrode, a source electrode, and a drain electrode. The gate electrode is connected to the first signal line 1115, and the first signal line 1115 is used to control the switching transistor to turn on and off. The source electrode is connected to the second signal line 1116, and the drain electrode is connected to the pixel electrode 1117. In a case where the first signal line 1115 controls the switching transistor to turn on, the source electrode and the drain electrode are conducted, and the second signal line 1116 transmits the second signal to the pixel electrode 1117, such that the liquid crystal molecules in the liquid crystal cell 1112 are deflected under the common drive of the pixel electrode 1117 and the common electrode.

To control each light-emitting unit individually, the number of control circuits 1114 is made to be equal to the total number of the plurality of first light-emitting units 102 and the plurality of second light-emitting units 104, such that each control circuit 1114 controls the deflection of the liquid crystal molecules in the liquid crystal cell 1112 disposed in a region where one light-emitting unit is disposed.

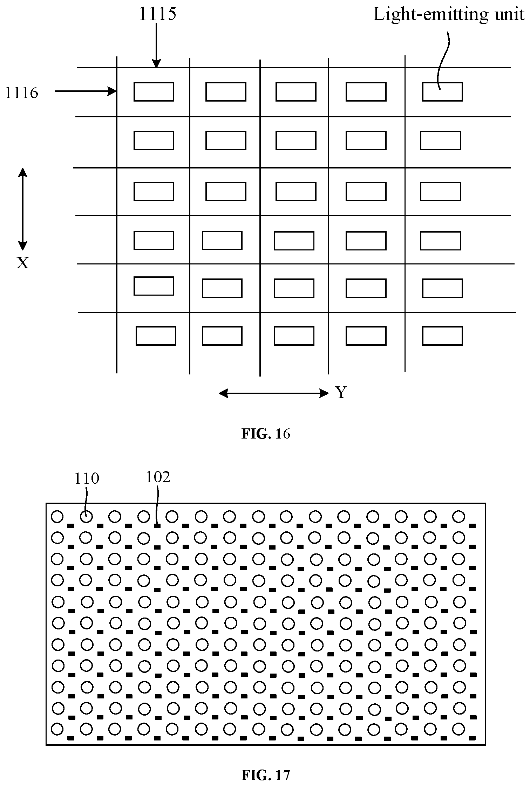

In some embodiments, the plurality of first signal lines 1115 and the plurality of second signal lines 1116 form a plurality of grid structures, and each of the control circuits 1114 is used to control the liquid crystal molecules in a region in which one grid structure is disposed. Referring to FIG. 16, the orthographic projection of each light-emitting unit on the first substrate 101 is within one of the grid structures, such that each control circuit 1114 controls liquid crystal molecules in the region where one light-emitting unit is disposed.

Referring to FIG. 14, the light-emitting module 10 further includes a color conversion layer 112 disposed on a side, away from the first substrate 101, of the plurality of second light-emitting units 104. Specifically, the color conversion layer 112 is disposed on a side, away from the first substrate 101, of the control panel 111.

In some embodiments, the light emitted by the plurality of first light-emitting units 102 and the plurality of second light-emitting units 104 is in a first color. The color conversion layer 112 includes a first color conversion portion, a second color conversion portion, and a light transmission portion. The first color conversion portion is to convert the light of the first color to the light of the second color, the second color conversion portion is to convert the light of the first color to the light of the third color, and the transparent portion is to transmit the light of the first color.

Exemplarily, the first color is blue, the second color is red, and the third color is green. The light after passing through the color conversion layer 112 includes red light, green light, and blue light. These three colors of light are combined to form white light, such that the color of the light emitted from the light-emitting module 10 is white. The first color conversion portion is doped with red quantum dots, and the second color conversion portion is doped with green quantum dots.

It should be noted that in some embodiments, the light-emitting module 10 does not include the color conversion layer 112, as long as the light emitted from the first light-emitting unit 102 and the second light-emitting unit 104 is white.

In some embodiments of the present disclosure, the first substrate 101 is a printed circuit board (PCB) and the second substrate 103 is a glass substrate. Alternatively, both the first substrate 101 and the second substrate 103 are glass substrates. The circuit board is thinner and softer as compared to the glass substrate, which is more suitable for scenarios where thinning is required.

In some embodiments of the present disclosure, the first light-emitting unit 102 is farther away from the control panel 111, while the second light-emitting unit 104 is closer to the control panel 111. Therefore, in a case where the first light-emitting unit 102 and the second light-emitting unit 104 are arranged in different regions, the light-emitting module 10 may not emit light uniformly. As a result, by arranging the first light-emitting unit 102 and the second light-emitting unit 104 staggered, the uniformity of light emission is improved.

That is, referring to FIG. 17, the orthographic projections of the plurality of first light-emitting units 102 on the first substrate 101 and the orthographic projections of the plurality of second light-emitting units 104 on the first substrate 101 are arranged staggered. FIG. 17 gives the description using a scenario where the first light-emitting unit 102 is not covered by the first protective portion 109 and the second light-emitting unit 104 is covered by the second protective portion 110 as an example.

Referring to FIG. 17, the shape of the orthographic projection of the second protective portion 110 on the first substrate 101 is circular, and the shape of the orthographic projection of the first light-emitting unit 102 on the first substrate 101 is rectangular. Alternatively, the shape of the orthographic projection of the first protective portion 109 on the first substrate 101 is the same as the shape of the orthographic projection of the second protective portion 110 on the first substrate 101, i.e., circular. The shape of the orthographic projection of the second light-emitting unit 104 on the first substrate 101 is the same as the shape of the orthographic projection of the first light-emitting unit 102 on the first substrate 101, i.e., rectangular.

In some embodiments, the plurality of first light-emitting units 102 and the plurality of second light-emitting units 104 are miniature light-emitting diodes, e.g., mini LEDs or micro LEDs.

In some embodiments, the number of first light-emitting units 102 designed on the first substrate 101 is the same as the number of second light-emitting units 104 designed on the second substrate 103. Of course, the number of first light-emitting units 102 designed on the first substrate 101 is different from the number of second light-emitting units 104 designed on the second substrate 103. The number of light-emitting units designed on the two substrates is not limited herein.

For example, the first light-emitting units 102 are arranged in n rows and n columns. That is, the number of the first light-emitting units 102 is n×n. The second light-emitting units 104 are arranged in m rows and m columns. That is, the number of the second light-emitting units 104 is m×m. In a case where the number of the first light-emitting units 102 designed on the first substrate 101 is the same as the number of the second light-emitting units 104 designed on the second substrate 103. then n is equal to m.

In summary, some embodiments of the present disclosure provide a light-emitting module including the first substrate, the plurality of first light-emitting units disposed on the first substrate, the second substrate, and the plurality of second light-emitting units disposed on the second substrate. Light emitted from the plurality of first light-emitting units is irradiated along the direction away from the first substrate through the aperture in the second substrate, and light emitted from the plurality of second light-emitting units is also irradiated along the direction away from the first substrate, such that the luminance of the light-emitting module is increased, and thereby the display effect of the display device is improved. Moreover, since the plurality of first light-emitting units and the plurality of second light-emitting units are respectively disposed on the two substrates, the light-emitting units disposed on the two substrates are controlled separately, which avoids an increase in the power of the driver chip in the light-emitting module, such that the phenomenon of localized heat generation in the light-emitting module is avoided, and thus the yield of the product is ensured.

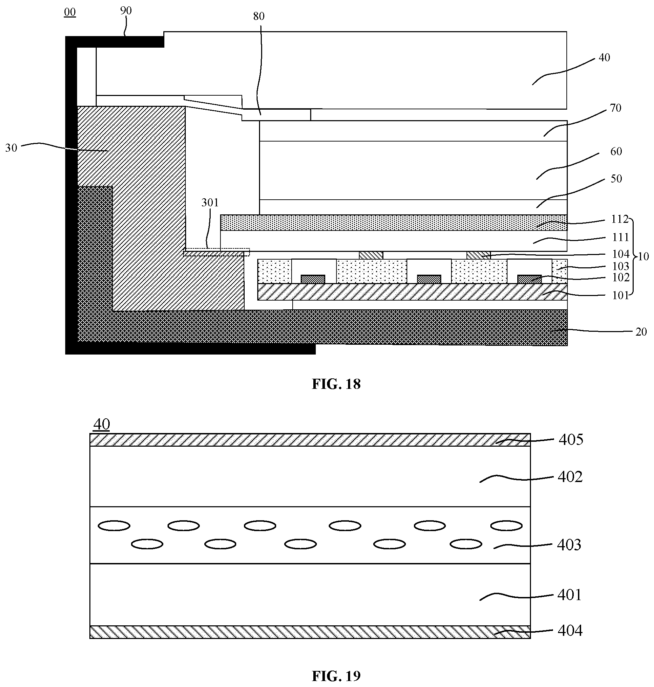

FIG. 18 is a partial schematic diagram of a display device according to some embodiments of the present disclosure. Referring to FIG. 18, the display device 00 includes a housing 20, an adhesive frame assembly 30, a display module 40, and a light-emitting module 10 as described above.

The housing 20 and the adhesive frame assembly 30 form a holding space, and the light-emitting module 10 is within the holding space. The display module 40 is disposed on a light-exiting side of the light-emitting module 10, which causes the light-emitting module 10 to provide backlighting for the display module 40.

In some embodiments, the display module 40 is a liquid crystal display module. For example, referring to FIG. 19, the display module 40 includes an array substrate 401, a color film substrate 402, wherein the array substrate 401 and the color film substrate 402 are oppositely arranged to form a cell, and a liquid crystal cell 403 disposed between the array substrate 401 and the color film substrate 402. The array substrate 401 includes a driver circuit for driving pixel units, and the driver circuit includes a thin film transistor. The color film substrate 402 includes a plurality of color resistors of different colors, each of which is used for transmitting light of a corresponding color.

Further, referring to FIG. 19, the display module 40 includes a third polarizer layer 404 disposed on a side, away from the color film substrate 402, of the array substrate 401, and a fourth polarizer layer 405 disposed on a side, away from the array substrate 401, of the color film substrate 402.

Referring to FIG. 18, the housing 20 is disposed on a non-light-exiting side of the light-emitting module 10, and at least a portion of the housing 20 is disposed on a side of the light-emitting module 10. The adhesive frame assembly 30 includes a step structure 301.

In a case where the light-emitting module 10 includes a control panel 111 and does not include a color conversion layer 112, at least a portion of the control panel 111 in the light-emitting module 10 is disposed on the step structure 301. In a case where the light-emitting module 10 includes the color conversion layer 112 and does not include the control panel 111, at least a portion of the color conversion layer 112 of the light-emitting module 10 is disposed on the step structure 301. In a case where the light-emitting module 10 includes the control panel 111 and the color conversion layer 112, at least a portion of both the control panel 111 and the color conversion layer 112 is disposed on the step structure 301.

Since a plurality of apertures 103a are formed in the second substrate 103 of the light-emitting module 10 in the embodiments of the present disclosure, the second substrate 103 has a poor carrying capacity. As a result, by designing the step structure 301 in the adhesive frame assembly 30, the control panel 111 and/or the color conversion layer 112 is supported, such that the pressure of the control panel 111 and/or the color conversion layer 112 on the second substrate 103 is reduced, and thus the bearing effect on the control panel 111 and/or the color conversion layer 112 is improved.

In some embodiments, a width of the step structure 301 ranges from 0.4 mm to 0.5 mm. a width of a portion, overlapped with the step structure 301, of the control panel 111 and/or the color conversion layer 112 ranges from 0.25 mm to 0.3 mm.

With reference to FIG. 18, the display device 00 further includes a diffuser film 50, a homogenizer film 60, and a prism assembly 70 that are disposed between the light-emitting module 10 and the display module 40 and laminated successively.

The diffuser film 50 is configured to diffuse the light emitted from the light-emitting module 10, the homogenizer film 60 is configured to homogenize the light, and the prism assembly 70 is configured to converge the light.

Further, referring to FIG. 18, the display device 00 includes a contain tape 80. One end of the curtain tape 80 is disposed between the display module 40 and the prism assembly 70, and the other end is disposed between the display module 40 and the adhesive frame assembly 30. The curtain tape 80 serves to avoid side light leakage. The display device 00 also includes a flexible circuit board 90. One end of the flexible circuit board 90 is connected to the display module 40, and the other end of that is bent from a side edge to a side of the housing 20, such that the frame size of the display device 00 is reduced.

Further, the light-emitting module 10 has an adhesive material between the first substrate 101 and the housing 20, which achieves a fixed connection between the light-emitting module 10 and the housing 10. The adhesive material is a double-sided easy-open adhesive.

In addition, the display device further includes, but is not limited to, components such as an RF unit, a network module, an audio output unit, an input unit, a sensor, a display unit, a user input unit, an interface unit, a memory, a processor, and a power supply. Those skilled in the art should understand that the structure of the display device described above does not constitute a limitation of the display device, and the display device may include more or fewer of the components described above, a combination of certain components, or a different arrangement of components. In some embodiments of the present disclosure, the display device includes, but is not limited to, a monitor, a mobile phone, a tablet computer, a television, a wearable electronic device, a navigation display device, or the like.

In some embodiments, the display device is an LCD TV, an LCD monitor, a digital photo frame, a mobile phone, a tablet computer, or any other product or component with a display function.

Since the display device has essentially the same technical effects as the light-emitting module described above, the technical effects of the display device are not repeated herein for brevity.

The terms used in the detailed description of the present disclosure are merely for interpreting, instead of limiting, the embodiments of the present disclosure. It should be noted that unless otherwise defined, technical or scientific terms used in the embodiments of the present disclosure shall have ordinary meanings understandable by persons of ordinary skill in the art to which the disclosure belongs.

The terms used in the detailed description of the present disclosure are merely for interpreting, instead of limiting, the embodiments of the present disclosure. It should be noted that unless otherwise defined, technical or scientific terms used in the embodiments of the present disclosure shall have ordinary meanings understandable by persons of ordinary skill in the art to which the disclosure belongs. The terms "first," "second," and the like used in the embodiments of the present disclosure are not intended to indicate any order, quantity, or importance, but are merely used to distinguish the different components. The terms "comprise," "include," and derivatives or variations thereof are used to indicate that the element or object preceding the terms covers the element or object following the terms and its equivalents, and shall not be understood as excluding other elements or objects. The terms "connect," "contact," and the like are not intended to be limited to physical or mechanical connections, but may include electrical connections, either direct or indirect connection. The terms "on," "under," "left," and "right" are only used to indicate the relative positional relationship. When the absolute position of the described object changes, the relative positional relationship may change accordingly.

Described above are merely exemplary embodiments of the present disclosure, and are not intended to limit the present disclosure. Therefore, any modifications, equivalent substitutions, improvements, and the like made within the spirit and principles of the present disclosure shall be included in the protection scope of the present disclosure.

## Claims

1. A light-emitting module (10), comprising:
a first substrate (101);
a plurality of first light-emitting units (102), disposed on a target side of the first substrate (101);
a second substrate (103), having a plurality of apertures (103a) corresponding to the plurality of first light-emitting units (102), wherein an orthographic projection of each of the apertures (103a) on the first substrate (101) covers an orthographic projection of one of the first light-emitting units (102) on the first substrate (101), and light emitted from the plurality of first light-emitting units (102) is irradiated through the plurality of apertures (103a) toward a target direction (W), the target direction (W) being a direction away from the first substrate (101); and
a plurality of second light-emitting units (104), disposed in a region, where the plurality of apertures (103a) are not formed, in a side, away from the first substrate (101), of the second substrate (103), wherein an orthographic projection of each of the second light-emitting units (104) on the first substrate (101) is not overlapped with the orthographic projection of the first light-emitting unit (104) on the first substrate (101), and light emitted from the plurality of second light-emitting units (104) is irradiated toward the target direction (W).

2. The light-emitting module according to claim 1, wherein each of the plurality of apertures (103a) has a first aperture (k1) close to the first substrate (101) and a second aperture (k2) away from the first substrate (101);
wherein an area of an orthographic projection of the first aperture (k1) on the first substrate (101) is less than or equal to an area of an orthographic projection of the second aperture (k2) on the first substrate (101), and the orthographic projection of the first aperture (k1) on the first substrate (101), is within the orthographic projection of the second aperture (k2) on the first substrate (101).

3. The light-emitting module according to claim 2, wherein each of the plurality of apertures (103a) comprises a first aperture portion (103a1) and a second aperture portion (103a2), the first aperture portion (103a1) being close to the first substrate (101) with respect to the second aperture portion (103a2); wherein
the first aperture portion (103a1) has the first aperture (k1) and a third aperture (k3) opposite to the first aperture (k1), wherein an area of an orthographic projection of the third aperture (k3) on the first substrate (101) is equal to the area of the orthographic projection of the first aperture (k1) on the first substrate (101), and the orthographic projection of the third aperture (k3) on the first substrate (101) is overlapped with the orthographic projection of the first aperture (k1) on the first substrate (101); and
the second aperture portion (103a2) has the second aperture (k2) and a fourth aperture (k4) opposite to the second aperture (k2), wherein the area of the orthographic projection of the second aperture (k2) on the first substrate (101) is larger than an orthographic projection of the fourth aperture (k4) on the first substrate (101), and the orthographic projection of the second aperture (k2) on the first substrate (101) covers the orthographic projection of the fourth aperture (k4) on the first substrate (101).

4. The light-emitting module according to claim 3, wherein the third aperture (k3) is in communication with the fourth aperture (k4), the area of the orthographic projection of the third aperture (k3) on the first substrate (101) is equal to an area of the fourth aperture (k4) on the first substrate (101), and the orthographic projection of the third aperture (k3) on the third aperture (k3) is overlapped with the orthographic projection of the fourth aperture (k4) on the first substrate (101); and
an area of a cross-section, parallel to a bearing surface of the first substrate (101), of the second aperture portion (103a2) increases with an increase of a distance from the cross-section to the first substrate (101).

5. The light-emitting module according to any one of claims 1 to **4,** wherein the light-emitting module (10) further comprises: a first reflective portion (105) and a second reflective portion (106); wherein
the first reflective portion (105) is disposed between the first substrate (101) and the second substrate (103), and an orthographic projection of the first reflective portion (105) on the first substrate (101) is not overlapped with the orthographic projections of the plurality of apertures (103a) on the first substrate (101); and
the second reflective portion (106) is disposed on a side of the plurality of apertures (103a).

6. The light-emitting module according to any one of claims 1 to **4,** wherein the light-emitting module (10) further comprises: a third reflective portion (107) and a fourth reflective portion (108); wherein
the third reflective portion (107) is disposed on the side, away from the first substrate (101), of the second substrate (103), and an orthographic projection of the third reflective portion (107) on the first substrate (101) is not overlapped with the orthographic projections of the plurality of second light-emitting units (104) on the first substrate (101); and
the fourth reflective portion (108) is disposed on a side of the plurality of apertures (103a).

7. The light-emitting module according to any one of claims 1 to 6, wherein the light-emitting module (10) further comprises: a plurality of first protective portions (109) corresponding to the plurality of first light-emitting units (102), and a plurality of second protective portions (110) corresponding to the plurality of second light-emitting units (104); wherein
each of the plurality of first protective portions (109) is disposed within one of the apertures (103a) and on a side, away from the first substrate (101), of the first light-emitting units (102), and an orthographic projection of each of the first protective portions (109) on the first substrate (101) covers the orthographic projection of the first light-emitting unit (102) on the first substrate (101); and
each of the plurality of the second protective portions (110) is disposed on a side, away from the first substrate (101), of one of the second light-emitting units (104), and an orthographic projection of each of the second protective portions (110) on the first substrate (101) covers the orthographic projection of the second light-emitting unit (104) on the first substrate (101).

8. The light-emitting module according to claim 7, wherein a thickness of the first protective portion (109) on a bearing surface perpendicular to the first substrate (101) is less than or equal to a thickness of the second substrate (103).

9. The light-emitting module according to any one of claims 1 to 8, wherein the light-emitting module (10) further comprises a control panel (111) disposed on a side, away from the first substrate (101), of the plurality of second light-emitting units (104); wherein
the control panel (111) comprises a first polarizer layer (1111), a liquid crystal cell (1112), and a second polarizer layer (1113) that are laminated along the direction away from the first substrate (101);
the first polarizer layer (1111) has a first light-transmissive axis, and the first polarizer layer (1111) is configured to generate polarized light whose polarization direction is parallel to the first light-transmissive axis; and
the second polarizer layer (1113) has a second light-transmissive axis, and the second polarizer layer (1113) is configured to transmit polarized light whose polarization direction is parallel to the second light-transmissive axis and absorb polarized light whose polarization direction is perpendicular to the second light-transmissive axis.

10. The light-emitting module according to claim 9, wherein the control panel (111) further comprises: a plurality of control circuits (1114) arranged in an array, a plurality of first signal lines (1115) arranged along a first direction (X) and extending along a second direction (Y), and a plurality of second signal lines (1116) arranged along the second direction (Y) and extending along the first direction (X), the first direction (X) being perpendicular to the second direction (Y); wherein
the plurality of control circuits (1114) form a plurality of first control circuit groups (A1) arranged along the first direction (X), wherein each of the first control circuit groups (A1) comprises a plurality of control circuits (1114) arranged along the second direction (Y), and each of the first signal lines (1115) is connected to the plurality of control circuits (1114) in one of the first control circuit groups (A1); and
the plurality of control circuits (1114) further form a plurality of second control circuit groups (A2) arranged along the second direction (Y), wherein each of the second control circuit (A2) comprises a plurality of control circuits (1114) arranged along the first direction (X), and each of the second signal lines (1116) is connected to the plurality of control circuits (1114) in one of the second control circuit groups (A2);
wherein each of the control circuits (1114) is configured to drive deflection of liquid crystal molecules in the liquid crystal cell (1112) under control of the first signal line (1115) and the second signal line (1116).

11. The light-emitting module according to claim 10, wherein a number of the control circuits (1114) is equal to a total number of the plurality of first light-emitting units (102) and the plurality of second light-emitting units (104); and
each of the control circuits (1114) is configured to control deflection of liquid crystal molecules in the liquid crystal cell (1112) disposed in a region where one of the light-emitting units is disposed.

12. The light-emitting module according to any one of claims 1 to 11, wherein the light-emitting module (10) further comprises: a color conversion layer (112) disposed on a side, away from the first substrate (101), of the plurality of second light-emitting units (104);
light emitted from the plurality of first light-emitting units (102) and the plurality of second light-emitting units (104) is in a first color, and the color conversion layer (112) comprises a first color conversion portion, a second color conversion portion, and a transparent portion; and
the first color conversion portion is configured to convert light of the first color into light of a second color, the second color conversion portion is configured to convert the light of the first color into light of a third color, and the transparent portion is configured to transmit the light of the first color.

13. The light-emitting module according to any one of claims 1 to 12, wherein the first substrate (101) is a circuit board and the second substrate (103) is a glass substrate; or
the first substrate (101) and the second substrate (103) are both glass substrates.

14. The light-emitting module according to any one of claims 1 to 13, wherein the orthographic projections of the plurality of first light-emitting units (102) on the first substrate (101) and the orthographic projections of the plurality of second light-emitting units (104) on the first substrate (101) are staggered.

15. The light-emitting module according to any one of claims 1 to **14,** wherein the plurality of first light-emitting units (102) and the plurality of second light-emitting units (104) are micro light-emitting diodes.

16. A display device (00), comprising: a housing (20), an adhesive frame assembly (30), a display module (40), and the light-emitting module (10) as defined in any one of claims 1 to 15;
wherein the housing (20) and the adhesive frame assembly (30) form a holding space, the light-emitting module (10) is disposed in the holding space, the display module (40) is disposed on a light-exiting side of the light-emitting module (10), and the light-emitting module (10) is configured to provide backlighting for the display module (40).

17. The display device according to claim 16, wherein the housing (20) is disposed on a non-light-exiting side of the light-emitting module (10), at least a portion of the housing (20) is disposed on a side of the light-emitting module (10), the adhesive frame assembly (30) is disposed on a side of the light-emitting module (10) and is fixedly connected to the housing (20), and the adhesive frame assembly (30) comprises a step structure (301); and
at least a portion of a control panel (111) in the light-emitting module (10) is disposed on the step structure (301) and/or, at least a portion of a color conversion layer (112) in the light-emitting module (10) is disposed on the step structure (301).

18. The display device according to claim 16 or 17, wherein
a width of the step structure (301) ranges from 0.4 mm to 0.5 mm; and
a width of a portion, overlapped with the step structure (301), of the control panel (111) and/or the color conversion layer (112) ranges from 0.25 mm to 0.3 mm.

19. The display device according to any one of claims 16 to 18, wherein the display device further comprises a diffuser film (50), a homogenizer film (60), and a prism assembly (70) that are disposed between the light-emitting module (10) and the display module (40) and successively laminated, and a color film layer disposed on a side, away from the light-emitting module (10), of the display module (40);
wherein the diffuser film (50) is configured to diffuse light emitted from the light-emitting module (10), the homogenizer film (60) is configured to homogenize light, and the prism assembly (70) is configured to converge light.

20. The display device according to any one of claims 16 to 19, wherein the display module (40) is a liquid crystal display module.
